# EUROPÄISCHE PATENTANMELDUNG

(11) **EP 1 300 858 A2**
(43) Veröffentlichungstag der Anmeldung: **09.04.2003**
(21) Anmeldenummer: 02020160.4
(22) Anmeldetag: 09.09.2002
(51) Int. Cl.: H01H 11/04

(54) **Verfahren zur Herstellung eines Sensorelementes, insbesondere Schaltelementes**

(30) Priorität: 04.10.2001 DE 10149165
(71) Anmelder: Bircher AG, CH-8222 Beringen (CH)
(72) Erfinder: de Jager, Godert, Dr., 8604 Volketswil (CH)
(74) Vertreter: Weiss, Peter, Dr.

(57) **Zusammenfassung**

Bei einem Verfahren zum Herstellen eines Sensorelementes (R₁ bis R₃), insbesondere Schaltelementes, mit wenigstens einem Trägerelement (1.1, 1.2) mit zumindest einer leitenden Schicht (2), welche mit einer geladenen oder aufladbaren Folie (3) belegt und auf diese zumindest eine Elektrodenschicht (6) aufgelegt wird, soll zum Verbinden von dem zumindest einen Trägerelement (1.1, 1.2) mit der zumindest einen Folie (3) und zumindest einer Elektrodenschicht (6), das Sensorelement (R₁ bis R₃) erhitzt werden, wobei vor, während oder nach dem Erhitzen das Sensorelement (R₁ bis R₃) einem elektrischen Feld ausgesetzt werden soll.

## Beschreibung

Die vorliegende Erfindung betrifft ein Verfahren zum Herstellen eines Sensorelementes, insbesondere Schaltelementes, mit wenigstens einem Trägerelement mit zumindest einer leitenden Schicht, welche mit einer geladenen oder aufladbaren Folie belegt und auf diese zumindest eine Elektrodenschicht aufgelegt wird sowie ein nach dem Verfahren hergestelltes Sensorelement.

Derartige Verfahren sowie derartige Sensorelemente sind in vielfältiger Form und Ausführung auf dem Markt bekannt und erhältlich. Vorzugsweise werden sie als Schaltelemente, wie Schaltmatten, Schaltleisten, Schaltstreifen, Schaltfelder od. dgl. in der Sicherheitstechnik eingesetzt. Wird bspw. das Trägerelement durch eine äussere Kraft beaufschlagt, so wird ein Ausgangssignal generiert, um einen bestimmten Schaltvorgang durch ein Signal weiterzuleiten.

Ferner sind auch Schaltmatten bekannt, die eine Folie beinhalten, welche einen hierzu ähnlichen Effekt zeigen. Diese Folie besteht aus einem Kunststoffschaum aus bspw. Polypropylen, welche im Produktionsprozess bei der Herstellung der Folie in noch nicht ganz erstarrtem Zustand in einem starken elektrischen Feld dauerhaft elektrisch aufgeladen wird. Dabei entsteht eine Folie, die auf der einen Seite positiv und auf der anderen Seite negativ geladen ist. Die Folie wird auf beiden Seiten mit einer leitenden Schicht versehen. Wird dieses Paket durch Druck senkrecht zur Oberfläche komprimiert entsteht eine Ladungsverschiebung proportional zum Druck, was eine messbare Proportionaldifferenz zwischen den leitenden Flächen bewirkt. Nachteilig daran ist, dass die Feder und/oder Dämpfungseigenschaften und damit die Empfindlichkeit einer derartigen Folie nicht variabel ist. Zudem ist es schwierig eine derartige Folie für unterschiedlich grosse oder auch kleine Kräfte herzustellen bzw. zu optimieren.

Ferner hat sich als nachteilig erwiesen, dass bei der Herstellung von Sensorelementen, bspw. im Plattenlaminatoren, bei welchem das Laminieren unter grossem Druck und hoher Temperatur erfolgt, die geladene Folie ihre Ladungstrennung verliert.

Werden niedrigere Laminatortemperaturen eingestellt, so leidet die Laminatqualität. Dem zu Folge ist nachteilig, dass bei höheren Laminatortemperaturen, zum Verbinden der einzelnen Schichten des Sensorelementes die Ladung auf der Folie ihre Ausrichtung verlieren. Hierdurch wird die Sensitivität des Sensorelementes stark beeinträchtigt, was ebenfalls unerwünscht ist.

Der vorliegenden Erfindung liegt die Aufgabe zugrunde, ein Verfahren sowie ein Sensorelement zu schaffen, mit welchen kostengünstig und auf effektive Weise die Laminatqualität des Sensorelementes sowie auch die Sensitivität des Sensorelementes, insbesondere die Empfindlichkeit verbessert werden soll.

Ferner soll das Sensorelement universeller einsetzbar für unterschiedliche Kräfte kostengünstig hergestellt werden.

Zur Lösung dieser Aufgabe führt, dass zum Verbinden von dem zumindest einen Trägerelement mit der zumindest einen Folie und zumindest einer Elektrodenschicht, das Sensorelement erhitzt wird, wobei vor, während oder nach dem Erhitzen das Sensorelement einem elektrischen Feld ausgesetzt ist.

Bei der vorliegenden Erfindung wird ein Laminieren von Sensorelemeten unter Temperaturen, bis zu bspw. 180°C durchgeführt, wobei zwischen einer Elektrodenschicht und einer Masse bzw. einer leitenden Schicht des Trägerelementes, zwischen welchen die aufladbare Folie angeordnet ist, eine Hochspannung vor, während und/oder nach dem Laminieren, insbesondere auch beim Abkühlprozess angelegt wird.

Hierdurch wird erreicht, dass einerseits das Sensorelement, insbesondere der Laminierprozess hochwertig ist und ein Sensorelement entsteht, welches sehr dauerhaft mechanischen hohen Beanspruchen ausgesetzt werden kann.

Dabei verbinden sich im Laminator die einzelnen Schichten des Sensorelementes miteinander, ggf. sind zwischen den einzelnen Schichten Klebstoffschichten vorgesehen.

Gleichzeitig wird durch das Anlegen der Hochspannung zwischen Elektrodenschicht und Trägerelement gewährleistet, dass auch bei den hohen Temperaturen eine Ladungsausrichtung auf der aufladbaren Folie erfolgt.

Dieses aus einzelnen Schichten aufgebaute Sensorelement kann dann im Laminator aufgeheitzt werden und zu einem geeigneten Zeitpunkt, wenn bspw. die aufladbare Folie durch Temperatureinwirkung erweicht ist, unter Hochspannung gesetzt werden.

Dadurch entsteht zwischen der Elektrodenschicht und der Masse bzw. zwischen der leitenden Schicht des Trägerelementes über die ganze Fläche der Folie ein starkes elektrisches Feld. Hierdurch können sich die Ladungen bzw. Ladungsträger in der Folie ausrichten. Die Hochspannung bleibt so lange eingeschaltet, bis das Laminat bzw. das verbundene Sensorelement genügend abgekühlt bzw. erstarrt ist.

Hierdurch wird eine dauerhafte Ladungstrennung der Folie erreicht, wobei gleichzeitig das Laminat bei optimaler Herstellungstemperatur qualitativ sehr hochwertig hergestellt werden kann.

Die Folie mit der ausgerichteten Ladungen, deren Ladung konstant ist, lässt sich bei Krafteinwirkung auf das Sensorelement mit bspw. auf eine Schaltmatte mit seiner leitenden Schicht gegen die Elektrodenschicht bewegen. Hierdurch wird zwischen Elektrodenschicht und leitender Schicht durch die Kapazitätsänderung eine Spannung erzeugt und gemessen, die proportional zur angelegten Kraft ist.

Durch das Einsetzen von zusätzlichen komprimierbaren Schichten und/oder Federelementen zwischen Folie bzw. Trägerelement und Elektrodenschichten, lässt sich ein Dämpfungsverhalten bzw. eine Federkonstante einstellen. Hierdurch lässt sich Einfluss nehmen auf den sich ändernden Abstand zwischen leitender Schicht und Elektrodenschicht, bei einer äusseren Krafteinwirkung, so dass durch die Abstandsänderung sich eine Kapazitätsänderung einstellt, was eine elektrische Spannung zur Folge hat, die ein Rückschluss auf die angelegte Kraft zulässt.

Dabei soll auch im Rahmen der vorliegenden Erfindung liegen, eine Mehrzahl von unterschiedlichen komprimierbaren Schichten und/oder Federelementen mit unterschiedlichen Materialeigenschaften einzusetzen.

Es können bspw. Schaumfolien, geprägte Metall und/oder Kunststoffolien, Metallfederelemente und/oder Streifenelemente aus Kunststoff oder Metall als komprimierbare Schichten und/oder Federelemente eingesetzt werden.

Auch soll im Rahmen der vorliegenden Erfindung liegen, die leitende Schicht als Trägerelement selbst auszubilden bzw. das Trägerelement als leitende Schicht auszubilden, wenn diese stabil genug ausgebildet sind.

Auch soll daran gedacht sein, eine komprimierbare Schicht bzw. das Federelement als aufladbare Folie direkt auszubilden, welche zwischen der Elektrodenschicht und der leitenden Schicht angeordnet sind.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
Figur 1 eine schematisch dargestellte Draufsicht auf ein erfindungsgemässes Sensorelement, insbesondere ein Schaltelement;
Figur 2 eine schematisch dargestellte Draufsicht auf ein weiteres Ausführungsbeispiel eines weiteren Sensorelementes gemäss Figur 1;
Figur 3 eine schematisch dargestellte Draufsicht auf ein weiteres Sensorelement, insbesondere Schaltelement gemäss den Figuren 1 und 2.

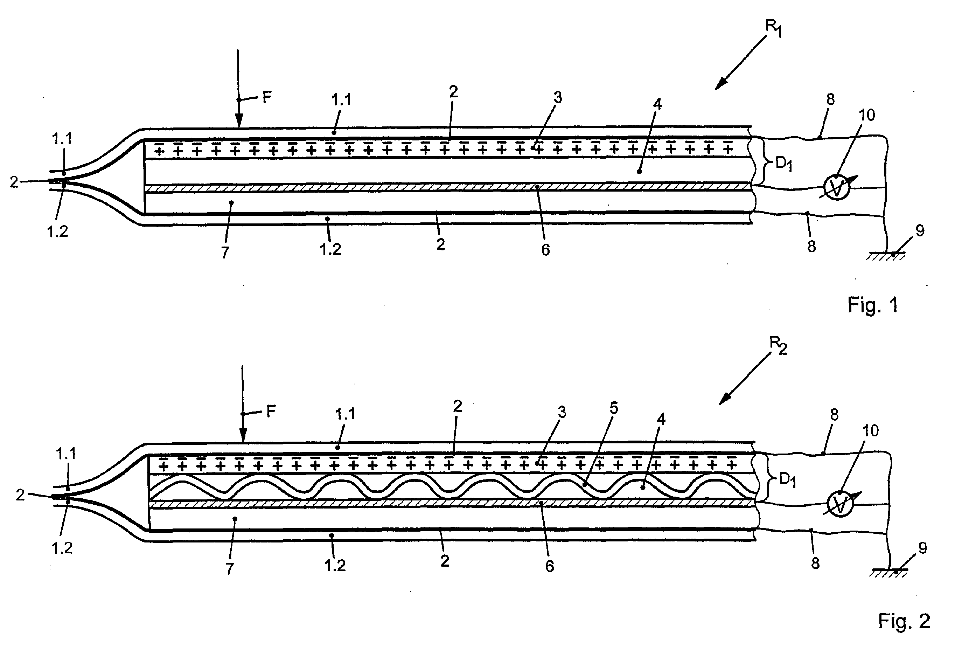

Gemäss Figur 1 weist ein erfindungsgemässes Sensorelement R₁ ein Trägerelement 1.1 und 1.2 auf, welche vorzugsweise parallel zueinander beabstandet angeordnet sind und eine nach innen gerichtete leitende Schicht 2 aufweist, die fest oder lose mit dem Trägerelement 1 verbunden sein kann. Als elektrisch leitende Schicht kann bspw. eine Metallschicht auf die Trägerelemente 1.1, 1.2 aufgedampft oder auflaminiert sein. Auch soll daran gedacht sein, das Trägerelement 1.1, 1.2 galvanisch zu behandeln, um die leitende Schicht 2 nach innen gerichtet aufzubringen. Auch soll daran gedacht sein, die leitende Schicht auf die Trägerelemente 1.1, 1.2 aufzudrucken. Diese kann auch als elektrisch leitende Kunststoffolie ausgebildet sein.

Vorzugsweise im Anschluss an das Trägerelement 1.1, wie es insbesondere in Figuren 1 und 2 dargestellt ist, schliesst eine geladene und/oder aufladbare Folie 3 an die leitende Schicht 2 des Trägerelementes 1.1 an. Die Folie 3 kann bspw. aus Polypropylen, Teflon oder aus Polyethylenterephthalate hergestellt sein.

Die Trägerelemente 1.1, 1.2 werden endseits vorzugsweise allseitig, wie es in Figur 1 angedeutet ist, zusammengeführt und miteinander verbunden. Dabei liegen die leitenden Schichten 2 leitend aufeinander.

Zwischen der Folie 3 und einem zwischen den Trägerelementen 1.1, 1.2 angeordneter Elektrodenschicht 6 ist eine komprimierbare Schicht 4, siehe Figur 1 und/oder ein Federelement 5, siehe Figur 2 eingesetzt. Vorzugsweise ist die kompirmierbare Schicht 4 elastisch verformbar.

Zwischen der Elektrodenschicht 6 und dem Trägerelement 1.2 ist eine Isolierschicht 7 vorgesehen.

Als komprimierbare Schicht 4 und/oder Federelement 5 können Schaumfolien, wie sie bspw. für herkömmliche Verpackungen verwendet werden, geprägte Metall und/oder Kunststoffolie, Metallfederelemente und/oder Kunststoffstreifenelemente eingesetzt werden. Auch soll vom vorliegenden Erfindungsgedanken mit umfasst sein, dass anstelle des Federelementes 5 bzw. anstelle der komprimierbaren Schicht 4 die Elektrodenschicht 3 als Federelement 5 bzw. komprimierbare Schicht 4 ausgebildet ist.

Wie ferner aus den Figuren 1 und 2 hervorgeht sind die leitenden Schichten 2 über Verbindungsleitungen 8 mit einer Masse 9 verbunden, wobei zwischen den Verbindungsleitungen 8 und der Elektrodenschicht 6 eine Messeinrichtung 10 eingesetzt ist.

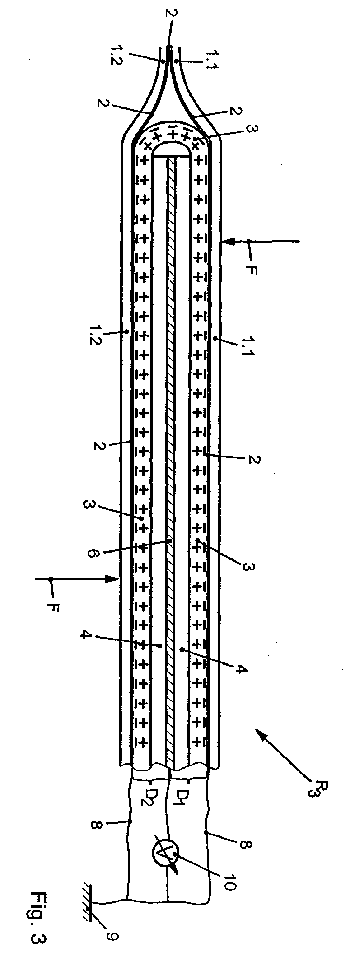

In dem Ausführungsbeispiel der vorliegenden Erfindung gemäss Figur 3 umgeben vorzugsweise zwei komprimierbare Schichten 4 die Elektrodenschicht 6.

Auch soll daran gedacht sein, zusätzlich das Trägerelement 1.2 ebenfalls mit einer elektrisch aufladbaren oder geladenen Folie 3 zu versehen, wobei die Folie des Trägerelementes 1.2 mit der Folie 3 des Trägerelementes 1.1 insbesondere im stirnseitigem Bereich zusammengeführt ist oder aus einer einzelnen Folie gebildet ist.

Durch die Verbindung von zwei komprimierbaren Schichten 4, die ggf. aus unterschiedlich dämpfenden Materialien, oder sogar aus unterschiedlichen Federelementen 5 gebildet sein können, lassen sich Dämpfungseigenschaften und Ansprechverhalten variieren.

Die Funktionsweise der vorliegenden Erfindung ist folgende:

Bei der vorliegenden Erfindung wird ein Sensorelement R₁ bis R₃, insbesondere ein Schaltelement, welches als Schaltmatte, Schaltleiste, Schaltstreifen, Schaltfeld od. dgl. ausgebildet sein kann, mittels einer externen äusseren Kraft F druckbeaufschlagt. Durch die Druckbeaufschlagung ändert sich ein Abstand D₁ zwischen Trägerelement 1.1, insbesondere leitender Schicht 2 und der Elektrodenschicht 6. Die Kondensatorspannung U ändert sich bei einer konstanten Ladung Q der aufladbaren Schicht 3, da sich die Kapazität C durch Änderung des Abstandes D₁ nach U =Q/C ändert. Wichtig ist, dass die Ladung Q der aufladbaren Schicht 3 konstant ist und sich lediglich Kapazität durch die Abstandsänderung D₁ ändert, was eine Änderung einer messbaren Spannung U zur Folge hat, die einen unmittelbaren Rückschluss auf eine auf das Sensorelement R₁ bis R₃ angelegte oder sich ändernde Kraft hat.

Durch die Änderung von Abstand D₁ zwischen leitender Schicht 2 und der Elektrodenschicht 6, ändert sich die Kapazität des Sensorelementes R₁ bis R₃, welche in der Messeinrichtung 10 eine Spannungsänderung zur Folge hat. Dieses Spannungspotential zwischen Masse 9 bzw. zwischen leitender Schicht 2 und Elektrodenschicht 6 lässt sich sehr genau messen.

Hierdurch lässt sich die aussen auf das Trägerelement 1.1 einwirkende Kraft F exakt bestimmen.

Hierdurch kann ein entsprechendes Signal bei einer erwünschten Kraft F generiert werden.

Wichtig bei der vorliegenden Erfindung ist jedoch, dass insbesondere nahe der leitenden Schicht 2 eine elektrisch aufgeladene Folie 3 vorgesehen ist, deren Ladungen, wie es in Figuren 1 bis 3 angedeutet ist, ausgerichtet sind.

Wird die Kraft auf das externe Trägerelement 1.1, 1.2 entfernt oder lässt die Kraft F nach, so wird die komprimierbare Schicht 4 und/oder das Federelement 5, welches der Kraft F entgegenwirkt, das Trägerelement 1.1 oder 1.2 im Bereich der Druckbeaufschlagung wieder in seine ursprüngliche Lage zurückbewegen, was ebenfalls wiederum durch die Änderung des Abstandes D₁ oder auch D₂, siehe Figur 3, eine messbare Spannung durch die Änderungen der Kapazität des Sensorelementes R₁ bis R₃ erzeugt. Werden gleiche komprimierbare Schichten 4, siehe Figur 3 verwendet, so ist eine lineare Kraftmessung hierdurch möglich.

Werden unterschiedliche komprimierbare Schichten 4, mit unterschiedlichen Dämpfungseigenschaften oder unterschiedliche Federelemente 5 mit unterschiedlichen Federkonstanten verwendet, so können auch progressive Kraftmessungen durch die Änderungen des Abstandes D₁ und/oder D₂ an der Messeinrichtung 10 erfolgen.

Dabei lässt sich bspw. einstellen, dass eine empfindliche Messung bei niedrigen Kräften F und eine unempfindliche Messung bei hohen anliegenden Kräften erfolgen soll. Dies soll ebenfalls im Rahmen der vorliegenden Erfindung liegen.

Wichtig ist ferner bei der vorliegenden Erfindung, dass bei der Herstellung der Sensorelemente R₁ bis R₃ zunächst die Trägerelemente 1.1, 1.2 ggf. mit schon aufgebrachten leitenden Schichten 2 auch entsprechend der Form der gewünschten Schaltmatte, Schaltleiste, Schaltstreifen oder Schaltfeld zugeschnitten werden. Anschliessend werden zwischen die Trägerelemente 1.1, 1.2 die geladene und/oder aufladbare Folie 3 aufgelegt, anschliessend die komprimierbare Schicht 4 und daran anschliessend die Elektrodenschicht 6 und nachgeschaltet diese Schicht 7, siehe Figur 1, eingelegt.

Damit die einzelnen Elemente 1.1, 1.2, 2, 3, 4 und/oder 5, 6 und 7 fest und unlösbar miteinander verbunden werden können, werden diese vorzugsweise mittels eines hier nicht dargestellten Plattenlaminator unter hohem Druck und unter hoher Temperatur, vorzugsweise bis zu 180° erhitzt, ggf. sind zwischen den einzelnen Schichten Klebstoffe eingebracht.

Hierdurch verschmelzen die einzelnen oben genannten Schichten miteinander und werden zu einem eigenständigen festen Sensorelement R₁ bis R₃ verbunden.

Unter der Temperatureinwirkung hat sich gezeigt, dass die Folie 3, sollte diese mit ausgerichteten Ladungen eingesetzt sein, die Ladungen ihre Ausrichtung verlieren.

Daher hat sich als besonderes vorteilhaft bei der vorliegenden Erfindung erwiesen, vor, während oder nach dem Erhitzen vorzugsweise im Plattenlaminator an die leitende Schicht 2 und die Elektrodenschicht 6, vorzugsweise dazwischen bei der Herstellung des Sensorelementes R₁ bis R₃ an eine vorzugsweise ungeladene Folie 3 eine Hochspannung anzulegen.

Dabei kann die Hochspannung zwischen Elektrodenschicht 6 und Masse 9 bzw. leitender Schicht 2 derart angelegt werden, dass sich die Ladungsträger der aufladbaren Folie 3 ausrichten.

Auch bei einem Abkühlen, nach dem Laminieren, insbesondere nach dem Zusammenverschmelzen der einzelnen Schichten des Sensorelementes R₁ bis R₃ bleibt die Hochspannung zwischen Elektrodenschicht 6 und Masse 9 bzw. leitender Schicht 2 aufrecht erhalten, bis eine kritische Abkühltemperatur erreicht ist, so dass sich die Ladung, insbesondere die Ausrichtung der Ladung der Folie 3 nicht mehr ändern kann. Hierdurch wird eine dauerhafte Ladungstrennung selbst bei einer optimalen Laminiertemperatur hergestellt werden, was einerseits zu einer sehr guten Qualität des Laminates, insbesondere des Sensorelementes R₁ bis R₃ führt und andererseits eine wirkungsvolle, dauerhafte Trennung der Ladung in der Folie 3 zur Folge hat.

Hierdurch bleibt permanent die Ladung der Folie 3 bzw. des Sensorelementes R1 bis R₃ konstant, wobei durch Änderung des Abstandes D₁ und/oder D₂ sich die Kapazität und damit eine messbare Spannung bei Kraftbeaufschlagung bzw. bei Abstandsänderung D₁ und/oder D₂ einstellt.

| **Positionszahlenliste** | | | | | |
|---|---|---|---|---|---|
| 1 | Trägerelement | 34 | | 67 | |
| 2 | leitende Schicht | 35 | | 68 | |
| 3 | Folie | 36 | | 69 | |
| 4 | komprimierbare Schicht | 37 | | 70 | |
| 5 | Federelement | 38 | | 71 | |
| 6 | Elektroden-schicht | 39 | | 72 | |
| 7 | Isolierschicht | 40 | | 73 | |
| 8 | Verbindungsleitung | 41 | | 74 | |
| 9 | Masse | 42 | | 75 | |
| 10 | Messeinrichtung | 43 | | 76 | |
| 11 | | 44 | | 77 | |
| 12 | | 45 | | 78 | |
| 13 | | 46 | | 79 | |
| 14 | | 47 | | | |
| 15 | | 48 | | | |
| 16 | | 49 | | R₁ | Sensorelement |
| 17 | | 50 | | R₂ | Sensorelement |
| 18 | | 51 | | R₃ | Sensorelement |
| 19 | | 52 | | | |
| 20 | | 53 | | | |
| 21 | | 54 | | | |
| 22 | | 55 | | F | Kraft |
| 23 | | 56 | | | |
| 24 | | 57 | | | |
| 25 | | 58 | | D₁ | Abstand |
| 26 | | 59 | | D₂ | Abstand |
| 27 | | 60 | | | |
| 28 | | 61 | | | |
| 29 | | 62 | | | |
| 30 | | 63 | | | |
| 31 | | 64 | | | |
| 32 | | 65 | | | |
| 33 | | 66 | | | |

## Patentansprüche

1. Verfahren zum Herstellen eines Sensorelementes (R₁ bis R₃), insbesondere Schaltelementes, mit wenigstens einem Trägerelement (1.1, 1.2) mit zumindest einer leitenden Schicht (2), welche mit einer geladenen oder aufladbaren Folie (3) belegt und auf diese zumindest eine Elektrodenschicht (6) aufgelegt wird,
**dadurch gekennzeichnet,**
**dass** zum Verbinden von dem zumindest einen Trägerelement (1.1, 1.2) mit der zumindest einen Folie (3) und zumindest einer Elektrodenschicht (6), das Sensorelement (R₁ bis R₃) erhitzt wird, wobei vor, während oder nach dem Erhitzen das Sensorelement (R₁ bis R₃) einem elektrischen Feld ausgesetzt ist.

2. Verfahren zum Herstellen eines Sensorelementes (R₁ bis R₃), insbesondere Schaltelementes, mit wenigstens einem Trägerelement (1.1, 1.2) mit zumindest einer leitenden Schicht (2), welche mit einer geladenen oder aufladbaren Folie (3) belegt und auf diese zumindest eine Elektrodenschicht (6) aufgelegt wird, **dadurch gekennzeichnet, dass** beim Verbinden von dem zumindest einen Trägerelement (1.1, 1.2) mit der zumindest einen Folie (3) und zumindest einer Elektrodenschicht (6), zwischen der leitenden Schicht (2) und der Elektrodenschicht (6) vor, während und/oder nach einem Erhitzen eine hohe Spannung angelegt wird.

3. Verfahren nach Anspruch 1 oder 2, **dadurch gekennzeichnet, dass** das Sensorelement (R₁ bis R₃) in einem Plattenlaminator unter Druck erhitzt wird.

4. Verfahren nach wenigstens einem der Ansprüche 1 bis 3, **dadurch gekennzeichnet, dass** während des Abkühlvorganges, nach dem Erhitzen das elektrische Feld oder die Spannung noch am Sensorelement (R₁ bis R₃) anliegen.

5. Verfahren nach Anspruch 4, **dadurch gekennzeichnet, dass** das elektrische Feld oder die Spannung bis zur Erreichung einer kritischen Temperatur anliegen und anschliessend abgeschaltet werden.

6. Verfahren nach wenigstens einem der Ansprüche 1 bis 5, **dadurch gekennzeichnet, dass** die leitende Schicht (2) mit dem Trägerelement (1.1, 1.2) verbunden wird oder diese aus dem Trägerelement (1.1, 1.2) selbst gebildet wird.

7. Verfahren nach wenigstens einem der Ansprüche 1 bis 6, **dadurch gekennzeichnet, dass** Trägerelement (1.1, 1.2), die leitende Schicht (2) die geladene oder aufladbare Folie (3) und die Elektrodenschicht (6) zum Sensorelement (R₁ bis R₃) unter Temperaturbeaufschlagung miteinander verschmolzen, insbesondere miteinander laminiert werden.

8. Verfahren nach wenigstens einem der Ansprüche 1 bis 7, **dadurch gekennzeichnet, dass** dem Trägerelement (1.1 und/oder 1.2) die leitende Schicht (2) aufgedampft, auflaminiert, galvanisch aufgetragen oder aufgedruckt wird.

9. Verfahren nach wenigstens einem der Ansprüche 1 bis 8, **dadurch gekennzeichnet, dass** zwischen dem Trägerelement (1.1 und/oder 1.2) mit leitender Schicht (2) und der Elektrodenschicht (6) zumindest ein Federelement (5) und/oder eine komprimierbare Schicht (4) eingesetzt wird.

10. Verfahren nach wenigstens einem der Ansprüche 1 bis 9, **dadurch gekennzeichnet, dass** durch eine Änderung eines Abstandes (D₁) von Trägerelement (1.1, 1.2) mit leitender Schicht (2) zur Elektrodenschicht (6) eine Änderung der Kapazität des Sensorelementes (R₁ bis R₃) eine Spannung erzeugt wird, welche messbar ist, und einen Rückschluss auf die auf das Trägerelement (1.1, 1.2) angelegte äussere Kraft (F) zulässt.

11. Verfahren nach wenigstens einem der Ansprüche 1 bis 10, **dadurch gekennzeichnet, dass** durch eine Änderung eines Abstandes (D₁) von Trägerelement (1.1, 1.2) mit leitender Schicht (2) zur Elektrodenschicht (6) eine Änderung der Kapazität des Sensorelementes (R₁ bis R₃) messbar ist, welche Rückschluss auf die auf das Trägerelement (1.1, 1.2) angelegte äussere Kraft (F) zulässt.

12. Verfahren nach Anspruch 10 oder 11, **dadurch gekennzeichnet, dass** zwischen Elektrodenschicht (6) und dem Trägerelement (1.2) eine Isolierschicht (7) eingesetzt wird.

13. Sensorelement, insbesondere Schaltelement mit wenigstens einem Trägerelement (1.1, 1.2), welcher zumindest eine leitende Schicht (2) aufweist und zwischen dieser und zumindest einer Elektrodenschicht (6) zumindest eine geladene oder aufladbare Folie (3) vorgesehen ist,
**dadurch gekennzeichnet,**
**dass** vor, während und/oder nach einem Erhitzen zum Verbinden von Trägerelement (1.1, 1.2) mit leitender Schicht (2), Folie (3) und Elektrodenschicht (6) zwischen Elektrodenschicht (6) und leitender Schicht (2) eine wählbare und veränderbare Spannung anlegbar ist.

14. Sensorelement, insbesondere Schaltelement mit wenigstens einem Trägerelement (1.1, 1.2), welcher zumindest eine leitende Schicht (2) aufweist und zwischen dieser und zumindest einer Elektrodenschicht (6) zumindest eine geladene oder aufladbare Folie (3) vorgesehen ist, **dadurch gekennzeichnet, dass** zwischen Trägerelement (1.1 und/oder 1.2) mit leitender Schicht (2) und geladener oder aufladbarer Folie (3) und Elektrodenschicht (6) ein Federelement (5) und/oder eine komprimierbare oder elastisch verformbare Schicht (4) eingesetzt ist.

15. Sensorelement nach Anspruch 14, **dadurch gekennzeichnet, dass** Federelement (5) und/oder komprimierbare und/oder elastisch verformbare Schicht (4) als geladene oder wieder aufladbare Folie (3) ausgebildet sind.

16. Sensorelement nach Anspruch 14, **dadurch gekennzeichnet, dass** das Federelement (5) als gewellte Metallschicht als elastisch verformbare Folie (3) oder als elastisch verformbarer Schaum ausgebildet ist.

17. Sensorelement nach wenigstens einem der Ansprüche 14 bis 16, **dadurch gekennzeichnet, dass** die komprimierbare und/oder elastisch verformbare Schicht (4) als Isolierschicht (7) ausgebildet ist.

18. Sensorelement nach wenigstens einem der Ansprüche 13 bis 17, **dadurch gekennzeichnet, dass** an die Elektrodenschicht (6) eine weitere Isolierschicht (7) anschliesst auf welcher ein weiteres Trägerelement (1.1, 1.2) mit innenliegender leitender Schicht (2) anschliesst.

19. Sensorelement nach wenigstens einem der Ansprüche 13 bis 18, **dadurch gekennzeichnet, dass** zwischen zwei Trägerelementen (1.1, 1.2) mit innenliegenden leitenden Schichten (2) die geladene oder aufladbare Folie (3) zumindest eine komprimierbare Schicht (4), eine Elektrodenschicht (6) und anschliessend eine Isolierschicht (7) dazwischen eingesetzt sind.

20. Sensorelement nach wenigstens einem der Ansprüche 13 bis 19, **dadurch gekennzeichnet, dass** zwischen zwei Trägerelementen (1.1, 1.2) mit innenliegenden leitenden Schichten (2) zumindest zwei Federelemente (5) und/oder elastisch verformbare und/oder kompimierbare Schichten (4) eingesetzt sind, wobei zwischen den beiden Federelementen (5) und/oder zwischen den beiden Schichten die Elektrodenschicht (6) vorgesehen ist.

21. Sensorelement nach wenigstens einem der Ansprüche 13 bis 20, **dadurch gekennzeichnet, dass** die Ladungen der geladenen oder aufladbaren Schicht (3), insbesondere Folie permanent ausgerichtet sind.

22. Sensorelement nach wenigstens einem der Ansprüche 13 bis 21, **dadurch gekennzeichnet, dass** die Ladungen der aufladbaren Schicht (3), insbesondere Folie durch Anlegen einer Spannung zwischen Elektrodenschicht (6) und dem zumindest einem Trägerelement (1.1, 1.2) unter Temperaturbeaufschlagung ausrichtbar sind, wobei vor, während oder nach der Temperaturbeaufschlagung die Spannung zum Ausrichten der Ladung auf der Schicht (3) angelegt ist.

23. Sensorelement nach wenigstens einem der Ansprüche 13 bis 22, **dadurch gekennzeichnet, dass** durch äussere Druckbeaufschlagung auf das zumindest eine Trägerelement (1.1, 1.2) ein Abstand (D₁ und/oder D₂) zwischen Trägerelement (1.1 und/oder 1.2) und der Elektrodenschicht (6) veränderbar ist, wobei die Änderung des Abstandes (D₁, D₂) eine Änderung der Kapazität zwischen Elektrodenschicht (6) und dem zumindest einen Trägerelement (1.1, 1.2) zur Erzeugung eines Signals oder zur exakten Bestimmung einer angelegten Kraft (F) ermittelbar ist.

24. Sensorelement nach wenigstens einem der Ansprüche 13 bis 23, **dadurch gekennzeichnet, dass** eine Mehrzahl von Schaltelementen übereinander legbar und miteinander verbindbar sind, wobei bei Druckbeaufschlagung eine Änderung des Abstandes (D₁, D₂) zwischen Trägerelement (1.1, 1.2) und Elektrodenschicht (6) eine Kapazitätsänderung und damit eine Ladungsverschiebung erfolgt, wobei eine Spannungsänderung zur Erzeugung und/oder Bestimmung eines Schaltsignals oder zur Bestimmung einer exakten angelegten Kraft (F) ermittelbar ist.
